# EUROPEAN PATENT APPLICATION

(11) **EP 4 772 888 A1**
(43) Date of publication of application: **08.07.2026**
(21) Application number: 24870625.1
(22) Date of filing: 20.09.2024
(51) Int. Cl.: G01R 19/17, G01R 31/00

(54) **LIGHTNING STRIKE COUNTING METHOD AND APPARATUS FOR COMMUNICATION POWER SUPPLY**

(30) Priority: 26.09.2023 CN 202311258023
(71) Applicant: ZTE CORPORATION, Shenzhen, Guangdong 518057 (CN)
(72) Inventor: LIU, Mingming, Shenzhen, Guangdong 518057 (CN); XIONG, Yong, Shenzhen, Guangdong 518057 (CN); HU, Xianhong, Shenzhen, Guangdong 518057 (CN)
(74) Representative: Chimini, Francesco
(86) International application number: PCT/CN2024/120129
(87) International publication number: WO 2025/067081

(57) **Abstract**

Embodiments of the present disclosure provide a lightning strike counting method and apparatus for a communication power supply, the method including: generating a plurality of sequential pulses for a plurality of ADCs in a time-interleaved analog-to-digital converter (TIADC); according to the plurality of sequential pulses, sequentially starting the plurality of ADCs to sample a lightning strike voltage and a lightning strike current; and sequentially outputting, by the plurality of ADCs, sampled signals, to complete lightning strike counting of the communication power supply.

## Description

### Cross-Reference to Related Application

The present disclosure is based on Chinese patent application no. CN 202311258023.8 filed on September 26, 2023 and entitled "Lightning Strike Counting Method and Apparatus for Communication Power Supply", and claims priority to the patent application, the disclosure of which is incorporated in the present disclosure by reference in its entirety.

### Technical Field

Embodiments of the present disclosure relate to the field of communications, and in particular, to a lightning strike counting method and apparatus for a communication power supply.

### Background

For communication equipment rooms, a lightning protection system generally includes an external lightning protection system and an internal lightning protection system. The external lightning protection system includes a lightning-capturing device for capturing lightning strikes, i.e. a lightning rod, a conductor guiding the current to the ground, i.e. a down conductor, and grounding devices such as a grounding electrode buried underground. The internal lightning protection system is correspondingly provided for preventing damage caused by lightning and surge from entering energized equipment, and includes dedicated equipment settings such as equipotential connection, a surge protector, a surge protective device for an alternating-current power supply, a signal surge protective device, and an antenna feeder surge protective device. Taking the surge protective device for a power supply as an example, according to zonal lightning protection and multi-level protection theory of IEC (International Electrotechnical Commission) standards, a first-level surge protective device (class-B lightning protection) is deployed on a main power distribution cabinet in an equipment room building, for discharging high-energy lightning current on a power supply line; a second-level surge protective device (class-C lightning protection) is deployed on a branch power distribution cabinet, so as to discharge the current again and reduce the residual voltage; and a third-level surge protective device (class-D lightning protection) is deployed at an input side of important equipment, so as to further discharge the current and reduce the voltage, and protect the safety of equipment ports and internal high-precision integrated circuits. Apparently, operating conditions and timely maintenance of all classes of surge protective devices are the key to ensuring safe operation of the system. In the industry, generally, a lightning strike counter is used together with each of the surge protective devices to record and count the number of lightning strikes to which the surge protective device is subjected, which is an important basis for operation and maintenance personnel to perform targeted inspection on the surge protective device.

Currently, various lightning strike counters for a communication power supply on the market only simply record the number and time of lightning strikes, which serve as basic references for performance detection and service life estimation of the surge protective devices. Key operation parameters, such as the number of repeated impulses, time and discharge energy, during the lightning strikes are not precisely recorded, thus the local frequency of lightning strikes cannot be clearly and accurately learned, and the real operating conditions of the surge protective devices cannot be mastered, which cannot provide important basis for inspection of the surge protective devices.

### Summary

Embodiments of the present disclosure provide a lightning strike counting method and apparatus for a communication power supply.

According to some embodiments of the present disclosure, a lightning strike counting method for a communication power supply is provided, and includes: a plurality of sequential pulses are generated for a plurality of analog-to-digital converters (ADCs) in a time-interleaved analog-to-digital converter (TIADC); according to the plurality of sequential pulses, the plurality of ADCs are sequentially started to sample a lightning strike voltage and a lightning strike current; and sampled signals are sequentially output by the plurality of ADCs, to complete lightning strike counting of the communication power supply.

According to some other embodiments of the present disclosure, a lightning strike counting apparatus for a communication power supply is provided, and includes: a microprocessor, a beat generator, a voltage sensor, a current sensor, a time-interleaved analog-to-digital converter (TIADC), wherein the microprocessor is configured to generate a high-frequency clock; the beat generator is configured to generate a plurality of sequential pulses for a plurality of analog-to-digital converters (ADCs) in the TIADC according to the high-frequency clock; the voltage sensor is configured to collect a lightning strike voltage, and perform conditioning processing on the lightning strike voltage; the current sensor is configured to collect a lightning strike current, and perform conditioning processing on the lightning strike current; and the TIADC is configured to sequentially start, according to the plurality of sequential pulses, the plurality of ADCs to sample the lightning strike voltage and the lightning strike current.

### Brief Description of the Drawings

Fig. 1 is a block diagram of a hardware structure of a computer terminal of a lightning strike counting method for a communication power supply according to embodiments of the present disclosure;
Fig. 2 is a flowchart of a lightning strike counting method for a communication power supply according to embodiments of the present disclosure;
Fig. 3 is a structural block diagram of a lightning strike counting apparatus for a communication power supply according to embodiments of the present disclosure;
Fig. 4 is an overall architecture diagram of a lightning strike counting apparatus according to embodiments of the present disclosure;
Fig. 5 is a schematic diagram of collection of voltage and current signals according to embodiments of the present disclosure;
Fig. 6 is a schematic diagram of collection of temperature and humidity signals according to embodiments of the present disclosure;
Fig. 7 is a principle diagram of lightning strike counting and timing according to embodiments of the present disclosure;
Fig. 8 is a schematic principle diagram of generation of sequential pulses according to embodiments of the present disclosure;
Fig. 9 is a schematic principle diagram of sequentially starting sampling of voltage and current signals and latching same according to embodiments of the present disclosure;
Fig. 10 is a schematic principle diagram of analog-to-digital conversion and output of signals according to embodiments of the present disclosure;
Fig. 11 is a principle diagram of an architecture of a central processing module according to embodiments of the present disclosure;
Fig. 12 is a principle diagram of a high-speed sampling interrupt response service process according to embodiments of the present disclosure; and
Fig. 13 is a principle diagram of a running process of a microprocessor background program according to embodiments of the present disclosure.

### Detailed Description of the Embodiments

Hereinafter, embodiments of the present disclosure are described in detail with reference to the accompanying drawings and in conjunction with the embodiments.

It is to be noted that the terms "first", "second", etc. in the description, claims and drawings of embodiments of the present disclosure are used to distinguish similar objects, and are not necessarily used to describe a specific sequence or a precedence order.

Lightning strike is a common natural phenomenon, and has characteristics such as large current, high voltage and short duration, which brings serious disasters to the human society due to its huge destructive power, and has an increasingly serious danger to national economy and life safety. One lightning strike may cause instantaneous breakdown and damage of communication equipment at a cost of millions of yuan, instant interrupt of communication networks, and even cause fires and personnel casualties, resulting in immeasurable disasters and accident-related losses to modern information society. Therefore, communication operators are all actively implementing lightning protection and disaster-mitigation measures to reduce disaster-related impacts to the minimum, and to ensure the communication network security and enterprise benefits.

At present, there are mainly the following three types of lightning strike counters on the market.

The most common lightning strike counting apparatus is generally mounted using a 35 mm DIN rail, and uses a dedicated electromagnetic mechanical counter for lightning strike counting. The basic principle thereof is that when a lightning strike occurs, a lightning arrester acts, the voltage drop on a nonlinear resistor of a high-temperature valve plate charges an energy storage capacitor via bridge rectification, and then the capacitor discharges a coil of an electromagnetic counter; and an inductive current flows through the coil, to induce an electromagnetic field, an internal iron core is magnetized, and an armature is pulled in to make a counter pointer rotate, so as to complete counting. Obviously, the speed of such a counter is slow, and such a counter also records the number of lightning strikes, and the timing interval is at least 1 s or longer; furthermore, in order to prevent the counter from being rusted due to moisture or being damaged, the counter is integrally sealed in a plastic box, and the interior of the box is potted with epoxy, so as to ensure the sealing performance; and during use, a cover of the box is strictly prohibited from being opened.

In addition, there is also an intelligent lightning strike counter. 220 V AC of a power supply supplies power to the lightning strike counter, and a ground wire of a lightning arrester passes through a transformer coil of the counter, wherein the display mode is generally LED lamp tube and liquid crystal display. When a lightning strike intrudes into a line, the lightning arrester acts, and when the lightning current is discharged to the ground, the transformer sleeved on the ground wire sends a collected current signal to an operation and comparison circuit of the counter, so as to achieve lightning strike counting; moreover, a clock chip is built in the counter, and can record year-month-day-hour-minute-second information of a lightning strike moment; and the counter can support a maximum of 1K lightning strike records, has a power-off memory function, and also supports remote monitoring via communication interfaces such as RS485/Ethernet. Obviously, such a counter also records the number of lightning strikes, and the timing interval is at least 100 ms or longer.

One lightning strike discharge typically involves multiple repeated impulse discharges. A typical lightning discharge includes two or three lightning strikes, the time interval between two lightning strikes is about one-twentieth of a second, and the duration of most lightning current is typically less than 100 us. Statistically, approximately 55% of lightning strikes include two or more impulses, with 3 impulses accounting for 25% and 10 or more impulses accounting for 4%; and the average number of repeated impulses is 3, and the maximum recorded number of repeated impulses is 42. Regarding the durations of lightning discharges, 50% of the lightning discharges last shorter than 0.2 S, while only 5% of the lightning discharges exceed 0.62 S. The lightning current waveforms are also substantially consistent, with a wave front of about 1-10 us and a pulse width of 20-100 us, averaging approximately 50 us, and pulse width longer than 50 us accounting for only about 18-30%. Accordingly, recording the number and duration of impulse discharges can more accurately reflect the lightning strike conditions; and recording the magnitude of leakage current of the lightning arrester can more directly reflect the energy of the lightning strike and the performance of the lightning arrester. Both the two technical solutions simply record and count the number of lightning strikes, but cannot record the whole process of the lightning strike discharge, including the number of impulse discharges, the duration, and the magnitude of leakage current, etc.; therefore, the local frequency of lightning strikes cannot be clearly and accurately learned, and the real operating conditions of surge protective devices cannot be mastered, which cannot provide reference basis for inspection of the surge protective devices.

Of course, on the market, there are also very specialized intelligent terminals for inspecting the operating conditions of lightning arresters, which can achieve comprehensive monitoring of lightning current parameters: peak value, effective value, wavefront, duration, energy, number of times, etc.; and the products are also integrated with solar panels, lithium batteries and GPS. However, they are usually applied to medium-high-voltage power distribution networks of 10 KV-750 KV; in addition, the volume and cost are very high, and are not suitable for being widely configured and used in communication equipment rooms and power supply equipment.

As such, embodiments of the present disclosure provide a lightning strike counter apparatus which can be widely applied to communication equipment rooms and power supply equipment, and can quickly, accurately and completely record and faithfully reproduce a lightning strike discharge process. Moreover, said apparatus has high measurement precision, low cost, small volume, and has no sealing requirement; said apparatus enables users to clearly and intuitively learn the impulse frequency of lightning induction and master the operating condition of a surge protective device for a power supply; and said apparatus achieves real-time and accurate lightning strike recording and warning, completes the transition from preventive maintenance to predictive maintenance, and also better avoids lightning strike disasters while reducing maintenance costs, thereby ensuring communication network security and enterprise benefits.

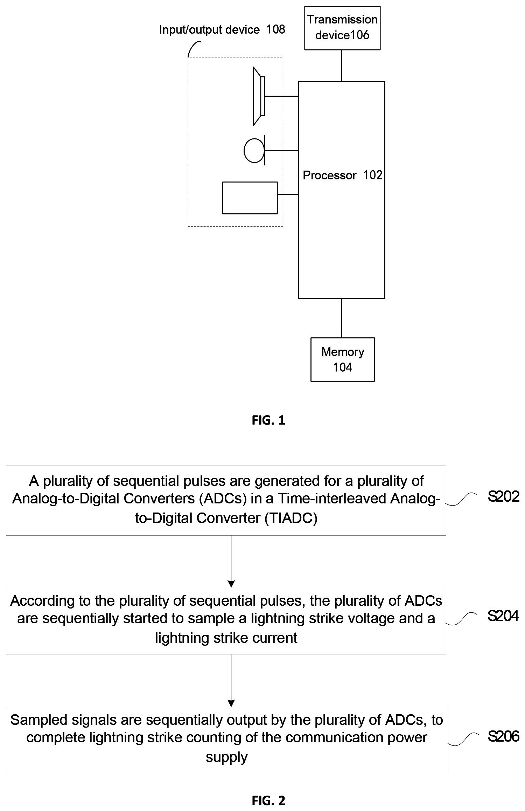

Method embodiments provided in the embodiments of the present disclosure can be executed in a mobile terminal, a computer terminal or a similar computing device. Taking the method embodiments being executed on a computer terminal as an example, Fig. 1 is a block diagram of a hardware structure of a computer terminal of a lightning strike counting method for a communication power supply according to embodiments of the present disclosure. As shown in Fig. 1, the computer terminal may include: one or more (Fig. 1 shows only one) processors 102 (the processors 102 may include, but not limited to processing device such as a microprocessor, MCU or a programmable logic device, FPGA), and a memory 104 configured to store data, wherein the computer terminal can further include a transmission device 106 and an input/output device 108 for communication functions. A person of ordinary skill in the art would understand that the structure shown in Fig. 1 is merely exemplary, and does not limit the structure of the computer terminal. For example, the computer terminal may also include more or fewer assemblies than those shown in Fig. 1, or have different configurations from that shown in Fig. 1.

The memory 104 may be used for storing a computer program, for example, a software program and module of application software, such as a computer program corresponding to the lightning strike counting method for a communication power supply in embodiments of the present disclosure; and the processor 102 executes all functional applications and data processing by running the computer program stored in the memory 104, i.e. implementing the described method. The memory 104 may include a high-speed random access memory, and may also include a non-transitory memory, such as one or more magnetic storage devices, flash memories or other non-transitory solid-state memories. In some examples, the memory 104 may further include memories remotely arranged with respect to the processors 102, and these remote memories may be connected to a mobile terminal via a network. Examples of the network include, but are not limited to the Internet, an intranet, a local area network, a mobile communication network and combinations thereof.

The transmission device 106 is used to receive or send data via a network. Specific examples of the network may include a wireless network provided by a communication provider of the computer terminal. In one example, the transmission device 106 includes a network adapter (Network Interface Controller, NIC) which may be connected to other network devices by means of a base station, thereby being able to communicate with the Internet. In one example, the transmission device 106 may be a radio frequency (RF) module which is configured to communicate with the Internet in a wireless manner.

The present embodiment provides a lightning strike counting method for a communication power supply running on the computer terminal. Fig. 2 is a flowchart of the lightning strike counting method for a communication power supply according to embodiments of the present disclosure. As shown in Fig. 2, the process includes the following steps:
step S202: a plurality of sequential pulses are generated for a plurality of Analog-to-Digital Converters (ADCs) in a Time-interleaved Analog-to-Digital Converter (TIADC).

In some exemplary embodiments, the plurality of sequential pulses are generated for the plurality of analog-to-digital converters (ADCs) in the time-interleaved analog-to-digital converter (TIADC), includes: frequency division processing is performed on a high-frequency clock, and the plurality of sequential pulses are generated according to the high-frequency clock after frequency division.

In a practical implementation process, after frequency division, the high-speed clock enters a beat generator (or a ring counter) to generate the plurality of sequential pulses.

Step S204: according to the plurality of sequential pulses, the plurality of ADCs are sequentially started to sample a lightning strike voltage and a lightning strike current.

In some exemplary embodiments, according to the plurality of sequential pulses, the plurality of ADCs are sequentially started to sample the lightning strike voltage and the lightning strike current, includes: the lightning strike voltage or the lightning strike current is simultaneously inputted to the plurality of ADCs, and the plurality of ADCs are sequentially started according to the sequential pulses to perform analog-to-digital conversion, so as to complete sampling of the lightning strike voltage or the lightning strike current.

In some exemplary embodiments, the plurality of ADCs are sequentially started to sample the lightning strike voltage and the lightning strike current, includes: m ADCs alternately sample the same lightning strike voltage or lightning strike current according to the plurality of sequential pulses; wherein the clock phase deviation between adjacent ADCs is 2π/m.

In a practical implementation process, the lightning voltage signal is simultaneously inputted to analog input ends of the m ADCs (the same applies to the lightning current); and the sequential pulses Q1, Q2, Q3,..., Qm serve as sampling start signals of the ADCs, and the ADCs are sequentially started to perform analog-to-digital conversion. The alternately sampled signals are combined according to a time sequence, so as to realize high-speed sampling.

In some exemplary embodiments, when a lightning strike occurs, a general-purpose counter is used to count the number of lightning strikes, and high-speed counters are used to measure a single impulse duration of the lightning strike and a duration of an interval between impulses of the lightning strike.

In some exemplary embodiments, before the general-purpose counter is used to count the number of lightning strikes, and the high-speed counters are used to measure the single impulse duration of the lightning strike and the duration of the interval between impulses of the lightning strike, the method further includes: conditioning processing is performed on a leakage current of a lightning arrester, to obtain a comparison voltage; if the comparison voltage is greater than a first voltage threshold, it is determined that a lightning strike has occurred; and if the comparison voltage is greater than a second voltage threshold, it is determined to start sampling the lightning strike voltage and the lightning strike current; wherein the second voltage threshold is less than the first voltage threshold.

In a practical implementation process, as the second voltage threshold is less than the first voltage threshold, fast sampling can be started before triggering lightning counting, so as to record the wave front of the lightning current.

In some exemplary embodiments, the general-purpose counter is used to count the number of lightning strikes, and the high-speed counters are used to measure the single impulse duration of the lightning strike and the duration of the interval between impulses of the lightning strike, includes: a first level signal is obtained according to a comparison result of the comparison voltage and the first voltage threshold; according to a rising edge of the first level signal, the general-purpose counter is triggered to increase the counting number of lightning strikes by 1; if the first level signal is at a high level, a first high-speed counter is used to measure the single impulse duration of the lightning strike; and if the first level signal is at a low level, a second high-speed counter is used to measure the duration of the interval between impulses of the lightning strike.

In some exemplary embodiments, the general-purpose counter is used to count the number of lightning strikes, and the high-speed counters are used to measure the single impulse duration of the lightning strike and the duration of the interval between impulses of the lightning strike, further includes: a first interrupt response signal is triggered according to the rising edge of the first level signal, and the first high-speed counter acquires a timing start time of the single impulse duration of the lightning strike according to the first interrupt response signal; and a second interrupt response signal is triggered according to a falling edge of the first level signal, and the first high-speed counter acquires a timing end time of the single impulse duration of the lightning strike according to the second interrupt response signal.

In some exemplary embodiments, the high-speed counters are used to measure the single impulse duration of the lightning strike and the duration of the interval between impulses of the lightning strike, includes: the single impulse duration of the lightning strike and the duration of the interval between impulses of the lightning strike are measured by connecting the high-speed counters and the general-purpose counter in series.

In a practical implementation process, as the range requiring counting is wide, the high-speed counters and the general-purpose counter are connected in series, so as to reduce hardware costs while expanding the counting range. For example, one 8-bit high-speed counter and three 8-bit general-purpose counters may be connected in series to form a 32-bit counter, so as to implement a maximum counting of 4 G; and if the counter clock is 1.0 GHz, then the maximum duration of timing is 4 s.

In some exemplary embodiments, after the plurality of ADCs are sequentially started to sample the lightning strike voltage and the lightning strike current, the method further includes: a sampling result is latched.

In a practical implementation process, latching the sampling result is substantially allowing a microprocessor to take the sampling result of the previous cycle before the end of conversion of the next cycle, thereby reducing the real-time requirement for interrupt response-based conversion result reading, reducing the performance requirement and hardware cost of the microprocessor, and also improving the reliability of the system.

Step S206: sampled signals are sequentially output by the plurality of ADCs, to complete lightning strike counting of the communication power supply.

In some exemplary embodiments, the plurality of ADCs sequentially output sampled signals, includes: after the plurality of ADCs perform analog-to-digital conversion on the sampled signals, third interrupt response signals are triggered; an output of each of the ADCs is sequentially read on the basis of a first third interrupt response signal, until the output of the ADC is invalid; and according to an m-th third interrupt response signal, outputs of the ADCs are sequentially read from an output of an ADC of which reading of an (m-1)th third interrupt response signal has been completed, until sequential reading of the outputs of the plurality of ADCs is completed.

In a practical implementation process, after completing analog-to-digital conversion, each ADC outputs a "conversion complete" signal; and after the signal is used to latch the conversion result, a next sequential pulse may automatically start a next sampling cycle. According to different ADC chip requirements, the "conversion complete" signal may also require a short delay in order to complete reading and latching of sampled data. In a practical implementation process, a fast-sampling completion interrupt signal is generated only within the duration of a lightning strike. After the interrupt signal is generated, an interrupt response program of the microprocessor reads an input end of General-Purpose Input/Output (GPIO) first, specifies which ADC has completed the conversion, and then reads a conversion output value of the ADC.

By the described steps, a lightning strike counting method for a communication power supply is provided, in which a plurality of sequential pulses are generated for a plurality of ADCs in the time-interleaved analog-to-digital converter (TIADC); according to the plurality of sequential pulses, the plurality of ADCs are sequentially started to sample a lightning strike voltage and a lightning strike current; and the plurality of ADCs sequentially output sampled signals, to complete lightning strike counting of the communication power supply. Said method solves the problems in the related art that the local frequency of lightning strikes cannot be clearly and accurately learned, and the real operating conditions of surge protective devices cannot be mastered, and achieves the effects of accurately calculating the frequency of lightning strikes and mastering the real operating conditions of the surge protective devices.

From the description of the described embodiments, a person skilled in the art would have been able to clearly understand that the method in the described embodiments may be implemented by using software and necessary general hardware platforms, and of course may also be implemented using hardware, but in many cases, the former is a better embodiment. On the basis of such understanding, the portion of the technical solution of embodiments of the present disclosure that contributes in essence or to the related art may be embodied in the form of a software product, the computer software product being stored in a storage medium (such as an ROM/RAM, a magnetic disk and an optical disc); and the storage medium includes several instructions to cause a terminal device (which may be a mobile phone, a computer, a server or a network device, etc.) to perform the method according to the embodiments of the present disclosure.

The present embodiment further provides a lightning strike counting apparatus for a communication power supply, the apparatus is configured to implement the described embodiments and preferred embodiments, and what has been described will not be repeated again. As used below, the term "module" may implement a combination of software and/or hardware of predetermined functions. Although the apparatus described in the following embodiments is preferably implemented in software, implementation in hardware or a combination of software and hardware is also possible and could have been conceived.

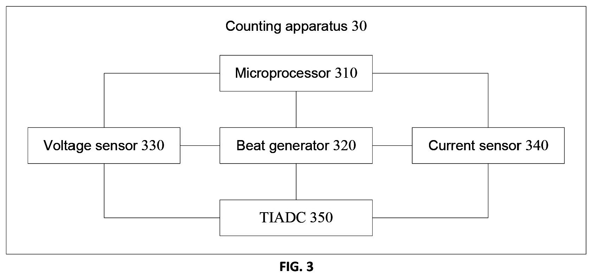

Fig. 3 is a structural block diagram of the lightning strike counting apparatus for a communication power supply according to embodiments of the present disclosure. As shown in Fig. 3, the counting apparatus 30 includes: a microprocessor 310, a beat generator 320, a voltage sensor 330, a current sensor 340, a time-interleaved analog-to-digital converter (TIADC) 350; wherein the microprocessor 310 is configured to generate a high-frequency clock; the beat generator 320 is configured to generate a plurality of sequential pulses for a plurality of analog-to-digital converters (ADCs) in the TIADC 350 according to the high-frequency clock; the voltage sensor 330 is configured to collect a lightning strike voltage, and perform conditioning processing on the lightning strike voltage; the current sensor 340 is configured to collect a lightning strike current, and perform conditioning processing on the lightning strike current; and the TIADC 350 is configured to sequentially start, according to the plurality of sequential pulses, the plurality of ADCs to sample the lightning strike voltage and the lightning strike current.

In some exemplary embodiments, the counting apparatus further includes: a general-purpose counter and high-speed counters; wherein the general-purpose counter is configured to count the number of lightning strikes; and the high-speed counters are configured to measure a single impulse duration of the lightning strike and a duration of an interval between impulses of the lightning strike.

In some exemplary embodiments, the counting apparatus further includes: a first voltage comparator and a second voltage comparator; wherein the first voltage comparator is configured to compare a comparison voltage with a first voltage threshold, determine whether a lightning strike has occurred, and output a first level signal; and the second voltage comparator is configured to compare the comparison voltage with a second voltage threshold, determine whether to start sampling the lightning strike voltage and the lightning strike current, and output a second level signal.

In some exemplary embodiments, the microprocessor 310 is further configured to trigger a first interrupt response signal according to a rising edge of the first level signal, wherein the first interrupt response signal is configured to instruct a first high-speed counter in the high-speed counters to acquire a timing start time of a single impulse duration of the lightning strike; and the microprocessor 310 is further configured to trigger a second interrupt response signal according to a falling edge of the first level signal, wherein the second interrupt response signal is configured to instruct the first high-speed counter to acquire a timing end time of the single impulse duration of the lightning strike.

In some exemplary embodiments, the microprocessor 310 is further configured to trigger third interrupt response signals after the plurality of ADCs sample the lightning strike voltage and the lightning strike current; wherein the third interrupt response signals are configured to instruct reading of outputs of the plurality of ADCs.

It should be noted that the described modules may be implemented by software or hardware. The latter may be implemented in the following manner, but is not limited thereto: all the described modules are located in the same processor; or all the modules above are located in different processors in any arbitrary combination manner.

For specific examples in the present embodiment, reference can be made to the examples described in the described embodiments and exemplary embodiments, and thus they will not be repeated again in the present embodiment.

It is apparent that a person skilled in the art shall understand that all of the modules or steps in embodiments of the present disclosure may be implemented by using a general computing device, may be centralized on a single computing device or may be distributed on a network composed of multiple computing devices. The modules or steps may be implemented by using executable program codes of the computing device, and thus, the program codes may be stored in a storage device and executed by the computing device, and in some cases, the shown or described steps may be executed in a sequence different from that shown herein, or the modules or steps are manufactured into integrated circuit modules, or multiple modules or steps therein are manufactured into a single integrated circuit module for implementation. Thus, embodiments of the present disclosure are not limited to any specific hardware and software combinations.

To make a person skilled in the art better understand the technical solutions of embodiments of the present disclosure, hereinafter, illustration is made in combination with scenario embodiments.

### Scenario Embodiment I

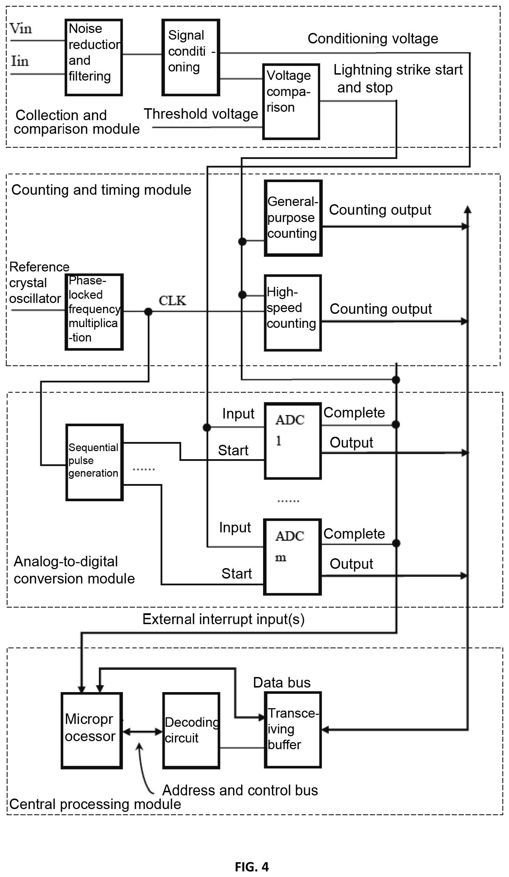

Fig. 4 is an overall architecture diagram of a lightning strike counting apparatus according to embodiments of the present disclosure. As shown in Fig. 4, the lightning strike counting apparatus includes four parts: a signal collection and comparison module, a lightning strike counting and timing module, an analog-to-digital conversion module and a central processing module. The signal collection and comparison module completes data collection and signal conditioning of lightning strike current and voltage signal sensors, and performs comparison to determine whether a lightning strike has occurred and whether to perform fast sampling; the lightning strike counting and timing module completes the accumulation of the number of lightning strikes and the timing of a single impulse duration; the analog-to-digital conversion module completes the sampling of lightning strike current and voltage; and the central processing module is composed of a microprocessor (DSP, MCU or MPU) minimal application system, is the brain of the apparatus, and is responsible for various functions such as reception, processing, storage, analysis, and execution of measurement data.

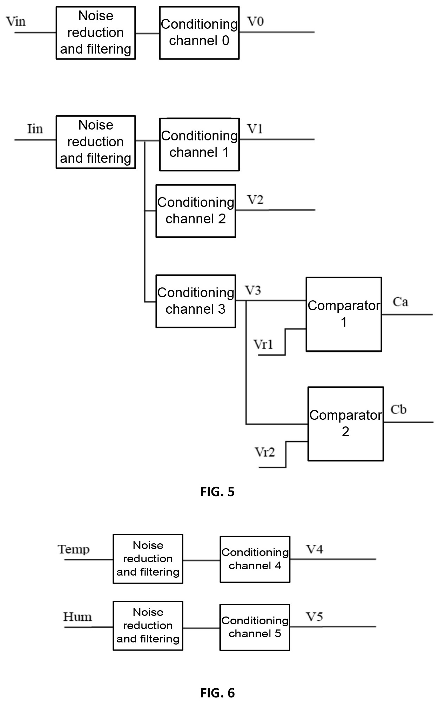

In a practical implementation process, the signal collection and comparison module completes data collection and signal conditioning of the lightning strike current and voltage signal sensors, and performs comparison and determination.
1. Collection of the lightning strike voltage signal: Fig. 5 is a schematic diagram of collection of voltage and current signals according to embodiments of the present disclosure. As shown in Fig. 5, a power grid voltage (a normal voltage or an overvoltage) borne by a lightning arrester is collected by a voltage sensor or a transformer. Since there are much noise and interference on a line during a lightning strike, it is necessary to first perform noise reduction and filtering on signals collected by the sensor, so as to obtain ideal data and then perform conditioning. The signal conditioning is actually converting each sensor signal into an appropriate voltage signal by an operational amplifier and clamping same to a certain value (for example, within an ADC analog input range), and outputting V0.
2. Collection of the lightning strike current signal: a leakage current (a lightning current or a total leakage current) of the lightning arrester is collected by a current sensor (such as a Rogowski coil). Similarly, the current signal collected by the sensor is first subjected to noise reduction and filtering, and then is conditioned. In order to improve the precision of ADC sampling, the collected signal is conditioned by three different channels respectively: the conditioning object of a first channel is to obtain a large lightning current, and provide clamped output V1; the conditioning object of a second channel is to obtain a weak total leakage current (typically in the range of 0-10 mA), and to provide clamped output V2 after gain amplification; and a third channel performs conditioning to output V3, which is used for comparison with a threshold voltage to determine whether a lightning strike has occurred and whether fast sampling needs to be performed:
   (1) V3 enters an input end of a voltage comparator 1, and is compared with a voltage threshold Vr1 (for example, corresponding to a lower-limit action current value of a surge protective device) set by the system, and Ca is outputted for determining whether a lightning strike has occurred: if the V3 value is lower than the threshold, the comparator outputs Ca at a low level, which indicates that no lightning strike has occurred; otherwise, Ca is a high-level signal, which indicates that a lightning strike has occurred; and
   (2) V3 enters an input end of a voltage comparator 2, and is compared with a voltage threshold Vr2 set by the system, and Cb is outputted for determining whether to perform fast sampling: if the V3 value is lower than the threshold, the comparator outputs Cb at a low level, which indicates that fast sampling is not required; otherwise, Cb is a high-level signal, which indicates that fast sampling is required. In addition, the set voltage threshold Vr2 needs to be slightly lower than Vr1, which indicates that before triggering lightning strike counting, fast sampling needs to be started to record the wave front of the lightning current.
3. Collection of temperature and humidity signals: Fig. 6 is a schematic diagram of collection of temperature and humidity signals according to embodiments of the present disclosure. As shown in Fig. 6, similar to the collection of lightning strike voltage signal, noise reduction and filtering are performed on the signal collected by the sensor, and after conditioning, clamped outputs are V4 and V5.

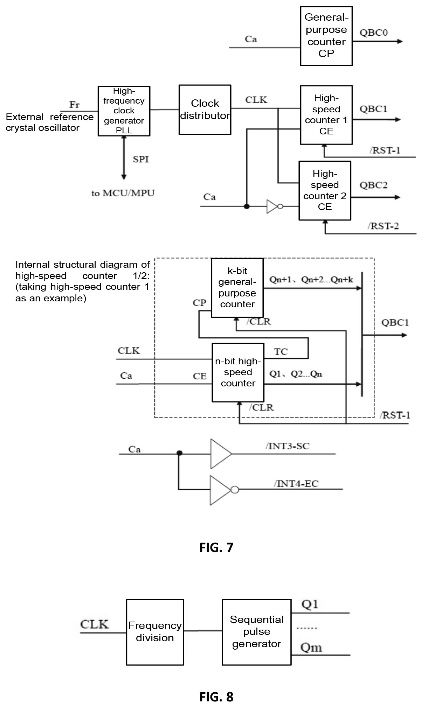

In a practical implementation process, the lightning strike counting and timing module completes the accumulation of the number of lightning strikes and the timing of a single impulse duration. Fig. 7 is a principle diagram of lightning strike counting and timing according to embodiments of the present disclosure. As shown in Fig. 7:
1. Accumulation of the number of lightning strikes: the comparator Ca signal outputted by the signal collection and comparison module is inputted to a clock input end of an "impulse times counter", and a rising edge of the Ca signal will trigger the counting of the counter to increase by one. A single impulse duration typically ranges from several tens of us to several hundreds of ms, the counting speed is slow, thus a general-purpose counter is used.
2. Timing of a single impulse duration: in order to faithfully reproduce a lightning strike discharge process, the single impulse duration needs to be accurately measured to reach a precision of ns level. Since a timer/counter built in a general-purpose microprocessor has low precision, a high-speed counting technology is used, which mainly includes three parts: high-frequency clock generation, clock distribution and high-speed counters:
   (1) High-frequency clock generation: a high-frequency clock is generated on the basis of a phase-locked frequency multiplication principle. The microprocessor communicates with a VCO-integrated high-frequency clock generator PLL to write a command word, and can control the output of the required high-frequency clock. If the high-frequency clock is 1.0 GHz, the timing precision of the duration can reach 1 ns.
   (2) Clock distribution: the high-frequency clock generated by the PLL is an analog signal, and the output power is also low; and conversion is performed by a clock frequency divider to obtain a clock source CLK (Clock) suitable for the high-speed counters.
   (3) High-speed counters: two high-speed counters are designed, for measuring an impulse duration and an interval between two impulses, respectively. Accordingly, enable ends of the counters are inputted to the comparator Ca signal. During a high-level Ca period, the impulse duration is measured; and during a low-level Ca period, the interval duration is measured. In addition, as the range requiring counting is wide, the high-speed counters and the general-purpose counter are connected in series, so as to reduce hardware costs while expanding the counting range. For example, one 8-bit high-speed counter and three 8-bit general-purpose counters may be connected in series to form a 32-bit counter, so as to implement a maximum counting of 4 G; and if the counter clock is 1.0 GHz, then the maximum duration of timing is 4 s.
3. Output of the counters: the comparator Ca signal is simultaneously inputted to two external interrupt input ends of the microprocessor: a rising edge triggers an interrupt program to acquire the timing of an impulse start time or the interval duration; and a falling edge triggers the interrupt program to acquire the timing of the impulse duration. After acquiring output values of the counters, the microprocessor immediately sends an active low-level signal to reset and clear the counters, for facilitating next counting.

In a practical implementation process, the analog-to-digital conversion module completes the sampling of lightning strike current and voltage. A TIADC technology is used to achieve high-speed sampling in a lightning strike impulse duration, whereas a conventional sampling technology is used in non-impulse time.
1. Conventional sampling: a general-purpose multiplexing analog-to-digital converter (ADC) chip is used to sample four signals, such as an alternating-current voltage, a total leakage current, temperature and humidity. The alternating-current voltage value can be used for determining the power grid quality in a normal time period (no lightning strike occurs); the total leakage current value may serve as an identification reference for the performance of a surge protective device; and sampled temperature and humidity are used to reduce the interference influence on the total leakage current, and improve the sampling accuracy of the total leakage current. After the ADC conversion is completed, a microprocessor program is triggered to acquire an analog-to-digital conversion result by means of an interrupt signal. Since the speed requirement of conventional sampling is low, generally it is only necessary to complete the sampling within approximately 1 s, and a cheap general-purpose ADC chip can be selected; in addition, if the microprocessor is integrated with ADC resources, the microprocessor may also be directly used, thereby further reducing hardware costs.
2. High-speed sampling: the TIADC technology is used to realize high-speed sampling of lightning voltage V0 and lightning current V1 within a lightning strike impulse duration, so as to conveniently reproduce a lightning strike waveform and calculate the impulse energy. The basic principle thereof is to use m ADCs to alternately sample the same input signal, and the clock phase deviation between adjacent ADCs is 2π/m; and then sampling results are combined, to achieve high-speed sampling. Specifically,

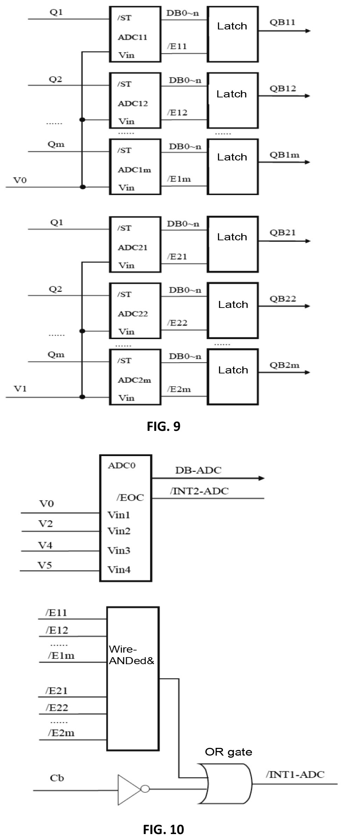

(1) m sequential pulses are generated: Fig. 8 is a schematic principle diagram of generation of sequential pulses according to embodiments of the present disclosure. As shown in Fig. 8, a high-speed clock CLK generated by the lightning strike counting and timing module is subjected to frequency division, and then enters a beat generator (or a ring counter), to generate m sequential pulses, i.e. Q1, Q2, Q3,..., until Qm; where m is a positive integer.
(2) Sampling are sequentially started: Fig. 9 is a schematic principle diagram of sequentially starting sampling of voltage and current signals and latching same according to embodiments of the present disclosure. As shown in Fig. 9, the lightning voltage V0 signal is simultaneously inputted to analog input ends of the m ADCs (the same applies to the lightning current V1); and the sequential pulses Q1, Q2, Q3,..., Qm serve as sampling start signals of the ADCs, and the ADCs are sequentially started to perform analog-to-digital conversion. For the lightning current V1, sampling is also performed in the same sequence.
(3) The sampling result is latched: after completing analog-to-digital conversion, each ADC outputs a "conversion complete" signal; and after the signal is used to latch the conversion result, a next sequential pulse may automatically start a next sampling cycle. According to different ADC chip requirements, the "conversion complete" signal may also require a short delay in order to complete reading and latching of sampled data. Latching the sampling result is substantially allowing the microprocessor to take the sampling result of the previous cycle before the end of conversion of the next cycle, thereby reducing the real-time requirement for interrupt response-based conversion result reading, reducing the performance requirement and hardware cost of the microprocessor, and also improving the reliability of the system.
(4) Interrupt notification processing: Fig. 10 is a schematic principle diagram of analog-to-digital conversion and output of signals according to embodiments of the present disclosure. As shown in Fig. 10, all "conversion complete" signals outputted after all the ADCs complete analog-to-digital conversion are inputted to a GPIO input end of the microprocessor; meanwhile, the signals are first wire-ANDed together, then ORed with an inverted signal of fast-sampling comparison output Cb, and then inputted to an external interrupt input end of the microprocessor. In other words, a fast-sampling completion interrupt signal is generated only within the duration of a lightning strike. After the interrupt signal is generated, an interrupt response program of the microprocessor reads the GPIO input end first, specifies which ADC has completed the conversion, and then reads a conversion output value of the ADC.

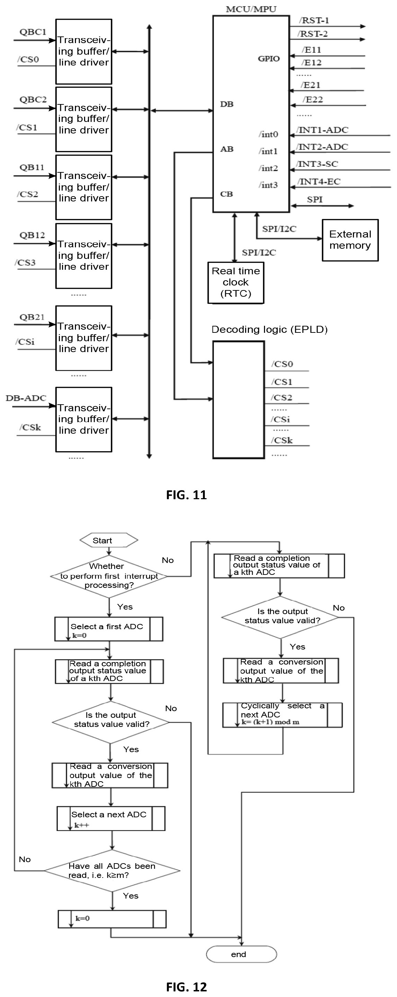

In a practical implementation process, the central processing module is composed of a microprocessor minimal application system. Fig. 11 is a principle diagram of an architecture of a central processing module according to embodiments of the present disclosure. As shown in Fig. 11, the central processing module is responsible for various functions such as reception, processing, storage, analysis, and execution of measurement data.
1. A high-frequency clock is generated: the microprocessor communicates with a Phase Locked Loop (PLL) integrated with a Voltage-Controlled Oscillator (VCO) via a Serial Peripheral Interface (SPI), to write a command word, and then controls the output of a required high frequency. For example, an ADF4360-6 chip is controlled to output a high-frequency clock of up to 1.2 G.
2. A software clock is generated: the microprocessor program generates a reference software timer interrupt, wherein the interrupt frequency is 1 ms. The tick value in the interrupt program increments continuously from 0 to 999, and is cyclically counted.
3. Decoding logic is constructed: by means of combination of logic and time sequence of an address bus and a control bus of the microprocessor (in modes such as an Erasable Programmable Logic Device (EPLD)), the decoding logic is completed, and then with the assistance of transceiving buffer of the data bus, read/write access to devices such as the timer and the ADCs is realized.
4. Calendar time (in millisecond precision) is acquired: there are two acquisition ways, and a first way is preferentially used.
   (1) The microprocessor extends a Real Time Clock (RTC) chip via buses such as an SPI or an Inter-Integrated Circuit (I2C) (some microprocessors have an RTC built therein, and can also be used directly). Some RTCs can also reach a subsecond precision of 1 ms, and after reading, an accurate calendar time (year-month-day-hour-minute-second-millisecond) can be directly obtained.
   (2) If the real time clock precision of RTC is only of a second level (year-month-day-hour-minute-second), the tick value in a software clock is used as the millisecond part of the calendar time. Obviously, in order to improve the precision, time synchronization (especially synchronization of the tick value) needs to be performed regularly via a network.
5. Fast timing and sampling: quick response and reception of data are achieved by four external interrupt input signals.
   (3) A rising edge of a Ca signal outputted by a lightning strike comparator triggers an interrupt: after the interrupt response program reads an output value and a carry output end of a high-speed counter 2, an active low-level signal is sent to clear the counter; and finally, the current calendar time (in millisecond precision) is acquired.
   (4) A falling edge of the Ca signal outputted by the lightning strike comparator triggers the interrupt: the interrupt response program completes the accumulation of the value of the impulse times, and after reading an output value of the high-speed counter 1 as the timing of impulse stop time, an active low-level signal is sent to clear the counter; and finally, the current calendar time (in millisecond precision) is acquired.
   (5) The completion of conventional sampling triggers an interrupt: after an alternating-current voltage V0, a total leakage current V2 of the lighting protector, temperature V4 and humidity V5 are sampled, the interrupt triggered after sampling is completed by using a general-purpose multiplexing ADC chip. The interrupt response program only needs to read converted data outputted by the ADC chip. V0 and V2 are alternating-current voltage and total leakage current value of the surge protective device in a normal period (no lightning strike has occurred). Of course, if a microprocessor-integrated ADC is used, the process is also the same. The only difference lies in that the ADC sampling complete interrupt is originated from within the processor.
   (6) Completion of high-speed sampling triggers an interrupt: Fig. 12 is a principle diagram of a high-speed sampling interrupt response service process according to embodiments of the present disclosure. As shown in Fig. 12, the interrupt triggered after sampling of the lightning voltage V0 and the lightning current V1 is completed via the TIADC. The TIADC consists of m ADCs. The interrupt response program first reads the GPIO input port, specifies which one of the m ADCs has completed the conversion, and then reads a conversion output value of the ADC. It should be particularly noted that, in the program, the conversion output values of the ADCs need to be read sequentially to avoid time misalignment:
      Step 1, During first response interrupt, software first reads output status values of all ADCs on the GPIO port; and from the first ADC (sequence number 0), the conversion output values of all ADCs having valid status are sequentially read, until a certain ADC status value is invalid; and the sequence number of the ADC is recorded as k, and obviously, 0≤k<m.
      Step 2, During a subsequent response interrupt, from k, the software circularly and sequentially reads completion output status values of kth, (k+1)th (starting from 0 if the value reaches m),..., ADCs on the GPIO port. If the status is valid, a corresponding ADC conversion output value is read, and if the status is invalid, the reading is stopped, and new invalid ADCs are sequentially numbered and reassigned to k.
      Step 3, Step 2 is repeated to complete sequential reading of the conversion output values of each of the ADCs.
      Step 4, It should be noted that since V0 and V1 are synchronously sampled, in the interrupt response program, the ADC conversion output values of V0 and V1 can be read at the same time.
6. Tasks such as data processing, storage and analysis are all executed in the program in a background mode.

(1) Data processing: the number of lightning strikes, impulse duration, and sampled raw data values read by a processor need to be processed for use.

Step 1, Data conversion: according to an input clock frequency of the high-speed counter, counting values of impulse duration and impulse interval are converted into intuitive time length values in s, ms, us and ns, etc.; and according to the amplification factor of a conditioning circuit, the sampled raw data value is converted into a voltage in V, a current in A, etc.

Step 2, Event identification: one lightning strike discharge typically involves multiple repeated impulse discharges. All the impulse interval durations are determined, so as to identify a lightning strike event. For example, if the interval duration is less than a threshold (such as 100 ms, the value can be set), the impulses are determined as multiple impulses in one lightning strike process; and if the interval duration exceeds the threshold, the impulses may be considered as another lightning strike event. As described above, in the interrupt response program of the rising edge of the Ca signal, the output value and carry output end of the high-speed counter 2, and the calendar time (in millisecond precision) are read. A new lightning strike discharge event is identified if one of the following three conditions is met:
□ the output value of the high-speed counter 2 is 0 (representing a first lightening impulse);
□ the output value of the high-speed counter 2 exceeds a threshold (representing that the interval duration is too long); and
□ the carry output end of the high-speed counter 2 is valid (representing that the interval duration is too long, and counter overflow occurs).

Step 3, Event recording: according to identification of the event, all pieces of data are integrated and aggregated, to generate event recording data, which includes:
□ the start time of this lightning strike event (year-month-day-hour-minute-second-millisecond), which can use the calendar time read in the interrupt response program;
□ the number of impulses of this lightning strike event;
□ monitoring data for each impulse discharge process, which includes:
   a. impulse duration (millisecond-microsecond-nanosecond), or expressed directly using a total nanosecond value; and
   b. an impulse voltage value and an impulse current value within an impulse duration (the sampling interval is fixed, i.e. the interval of the sequential pulses); and
□ monitoring data after each impulse discharge, which includes:
   a. an inter-impulse duration after the end of the impulse (millisecond-microsecond-nanosecond), or expressed directly using a total nanosecond value, i.e. the duration of an interval between two discharges; and
   b. a normal alternating-current voltage value and a total leakage current value (the conventional sampling has a long interval, which is on the order of approximately 1 s).

(2) Data storage: according to an event recording format, power-off storage of data is completed. The data is stored in memories such as a FLASH or an Electrically Erasable Programmable read only memory (EEPROM) that is externally expanded by the microprocessor via buses such as SPI/I2C. The storage mode is cyclic storage, and the amount of storage depends on the size of the memory.

(3) Data analysis: the data is further analyzed, to achieve more valuable applications:
Step 1, value parameter: analysis and calculation are performed, to obtain other parameters of an impulse discharge process, such as a current peak value, a residual voltage peak value, an effective value and energy; and
Step 2, precise counting: the data is analyzed, and lightning impulse and power grid fluctuation impact are identified so as to realize accurate counting. The lightning current waveform is generally a single-polarity pulse waveform, rises to a high peak in a short time, then slowly falls from the high peak, and presents an arched pulse shape; and the current waveform of induced lightning in communication stations and equipment rooms is similar to a waveform of 8/20 us. Therefore, by analyzing whether the lightning current waveform is approximate to an arched pulse of 8/20 us, it is determined whether the impulse is a lightning impulse or a power grid fluctuation impact, thereby avoiding mistakenly counting the power grid fluctuation impact into the number of lightning strikes.
Step 3, From the rising parts of several lightning current waveforms, it can be determined that the lightning current of subsequent negative lightning strikes exhibits a high rise speed, followed by a first negative lightning strike, and the first positive lightning strike shows the slowest rise. From the falling parts of the lightning current waveforms, it can be determined that the lightning current of subsequent negative lightning strikes falls faster than the first negative lightning strike, and the first negative lightning strike falls faster than the first positive lightning strike.
Step 4, Accurate monitoring: by means of a software compensation algorithm, the interference influence of temperature, humidity, etc. on the leakage current is reduced or eliminated, such that the status monitoring of the lightning arrester is more accurate.
Step 5, Operating condition prediction: according to multi-parameter criterion, such as Qrs of international or industry standards, the number of impulses and the leakage current, the operating condition of the lightning arrester can be effectively predicted and the service life is estimated.

### Scenario Embodiment II

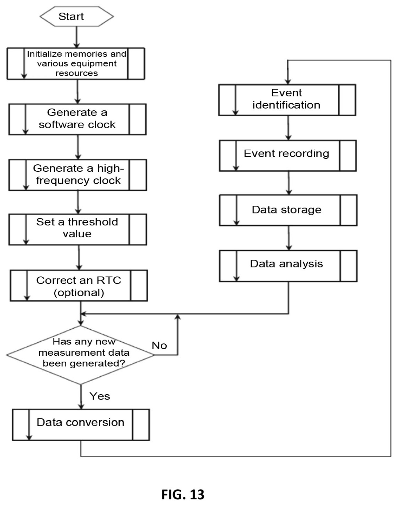

According to the general architecture of the lightning strike counting apparatus provided in Scenario Embodiment I, a specific process of lightning strike counting for a power supply is introduced in Scenario Embodiment II. Fig. 13 is a principle diagram of a running process of a microprocessor background program according to embodiments of the present disclosure. As shown in Fig. 13, the specific process is as follows:
I. Software in a microprocessor is powered on and started, to complete necessary initialization:
   1. Internal and external equipment resources such as memories and ADCs in a processor unit are initialized.
   2. A software clock is generated: the microprocessor program generates a reference software timer interrupt, wherein the interrupt frequency is 1 ms. The tick value in the interrupt program increments continuously from 0 to 999, and is cyclically counted.
   3. A high-frequency clock is generated: the microprocessor communicates with a VCO-integrated PLL via an SPI interface, to write a command word, and then controls the output of a required high-frequency clock. For example, an ADF4360-6 chip is controlled to output a high-frequency clock of up to 1.2 G.
   4. Thresholds are set: a voltage threshold Vr1 (corresponding to the current value for triggering lightning counting), a voltage threshold Vr2 (corresponding to the current value for starting fast sampling), and an interval duration threshold (if exceeding the value, an event will be considered as a next lightning strike event) are included.
   5. An (Real Time Clock)RTC is corrected: synchronous correction is regularly performed on an RTC calendar clock built in or externally expanded by the microprocessor (including a tick value in ms in a software clock) via a network. Whether these steps are executed may be determined according to actual situations.
II. The software in the microprocessor runs normally, and completes the measurement, processing, storage, analysis, etc. of signals such as voltage and current signals:
   1. A multiplexing ADC chip is periodically started, to alternately sample an alternating-current voltage, a total leakage current, temperature and humidity. After conversion by the ADC is completed, the system generates an external interrupt/INT2-ADC.
   2. Data is received by interrupt response: after an interrupt service program of the INT2-ADC runs, a conversion output value of the ADC is read.
   3. Background data processing: according to a sampling channel of a current ADC chip, received ADC sampling values are assigned, such as assigned to the alternating-current voltage value, the total leakage current, the temperature or humidity in a targeted manner. Then according to different conditioning circuits, sampled raw data values are converted into analog voltage, current, temperature or humidity values, such as converted into an alternating-current voltage of 220 V, or a temperature of 25°C.
   4. Background data recording: the current calendar time is read, to add a timestamp to the converted data, and then recording is performed.
   5. Background record storage: the recorded data with the timestamp is cyclically stored in memories such as FLASH/EEPROM.
   6. Background data analysis: according to the currently measured temperature and humidity values, the total leakage current value is corrected by a software compensation algorithm, so as to reduce the interference influence of temperature and humidity, etc. on the total leakage current. The performance of the lightning arrester can also be further analyzed by the magnitude of the total leakage current.
III. When a lightning strike event occurs, the software in the microprocessor will also complete high-speed sampling of the accumulation of the number of impulses, the timing of impulse duration and the duration of an interval between impulses, and the lightning voltage and the lightning current. Likewise, the reception, processing, storage and analysis of these data are achieved by means of interrupt response and background running.

1. Quick response and data reception are achieved by three external interrupt input signals.
   (1) The start of impulse triggers interrupt/INT3-SC: an interrupt response program reads an output value of a high-speed counter 2 and the current calendar time (in millisecond precision), as timing of the impulse start time or timing of the duration of the interval between impulses.
   (2) The end of the impulse triggers interrupt/INT4-EC: the interrupt response program completes the accumulation of the value of the number of impulses, and reads an output value of a high-speed counter 1 as the timing of impulse stop time.
   (3) Completion of high-speed sampling triggers interrupt/INT1-ADC: the interrupt response program first reads a GPIO input port, determines which ADC has completed conversion, and then reads a conversion output value of the ADC. The conversion output values of the ADCs need to be read according to a time sequence, so as to avoid misalignment.
2. Tasks such as data processing, storage and analysis are all executed in the program in a background mode.
   (1) Data processing: the number of lightning strikes, impulse duration, and sampled raw data values read by a processor need to be processed for use.
      (1) Data conversion: counting values, such as impulse duration and impulse interval are converted into a time length in unit of ms/us/ns; and the sampled raw values are converted into analog values such as voltage, current, temperature and humidity.
      (2) Event identification: One lightning strike discharge typically involves multiple repeated impulse discharges. A lightning strike event is identified by comparing the impulse interval duration with a threshold.
      (3) Event recording: according to identification of the event, all pieces of data are integrated and aggregated, to generate event recording data, including:
         □ the start time of this lightning strike event (year-month-day-hour-minute-second-millisecond);
         □ the number of impulses of this lightning strike event;
         □ monitoring data of each impulse discharge process, including an impulse duration, and impulse voltage and impulse current values which are rapidly collected; and
         □ monitoring data after each impulse discharge, including an impulse interval duration, and an alternating-current voltage value and a total leakage current value which are normally collected.
   (2) Data storage: according to an event recording format, power-off storage of data is completed.
   (3) Data analysis: the data is further analyzed and used.

### Scenario Embodiment III

In Scenario Embodiment III, actual data is used in combination and taken as an example for description.

A certain indoor communication direct-current power supply product produced by a certain company is deployed in a 2 m standard cabinet, and is configured with alternating-current power distribution, direct-current power distribution, a rectifier, a battery and a monitoring unit, wherein the capacity of a single rectifier is 50 A or 75 A, and the maximum output current of the system is 1200 A. The system supports alternating-current input of three-phase four-wire of 220/380 V AC, and is also configured with a surge protective device having a nominal discharge current of 10 kA and a waveform of 8/20 us, and a 32 A/3 P lightning protection air circuit breaker. In daily maintenance, usually, the color of a viewing window of the surge protective device is checked first. If the color of the viewing window is green, it indicates that the surge protective device is normal; and if the color of the viewing window is red, it indicates that the surge protective device is damaged due to voltage surge or lightning strike. Then, the state of the lightning protection air circuit breaker is checked. If the air circuit breaker is ON, it indicates a normal state, and if the air circuit breaker is OFF, it indicates that the input is disconnected. If the surge protective device is not damaged, it is only necessary to place the air circuit breaker in the ON state; otherwise, it indicates that the air circuit breaker is damaged. The damaged surge protective device and air circuit breaker need to be replaced as quickly as possible.

Obviously, in order to ensure the stability and safety of the power supply system, the surge protective device needs to be detected in time and replaced as soon as possible. Especially before or during a thunderstorm season, users or operation and maintenance personnel may be arranged to each site for inspection and investigation. In the current 5G network era, there are a large number of sites, and many sites are located in unattended deserted countryside where the traffic is inconvenient; moreover, only damaged surge protective devices can be found out; and there is nothing that can be done for surge protective devices that are about to be damaged, and also it is impossible to ensure that they can safely survive the thunderstorm season. Such scattershot, lowefficient, and even ineffective means of operation and maintenance may result in significant cost overhead. To this end, the embodiments of the present disclosure can change passive means into active means, wherein a lightning strike counter apparatus is added to a rear stage of the surge protective device, and by accurately and intuitively learning the frequency of lightning impulses, the operating condition of the surge protective device is grasped, the degradation trend of the surge protective device is calculated, and the service life of the surge protective device is predicted; and surge protective devices that are about to damage or fail to safely survive the thunderstorm season are timely replaced. Obviously, this method achieves the transition from preventive maintenance to predictive maintenance, and also better avoids lightning strike disasters while reducing maintenance costs, thereby ensuring communication network security and enterprise benefits.

Before the lightning strike counter apparatus is added, various parameters of the surge protective device on the power supply system need to be learned. The nominal discharge current In of the surge protective device is 10 kA, the maximum discharge current Imax is 20 kA, and the maximum continuous operating voltage Uc is 275 V. Therefore, the embodiments of the present disclosure can deploy the design and delivery operation of the lightning strike counter according to these operation parameters and user requirements:
1. A mainstream ARM/RTOS Advanced Reduced Instruction-Set Machine (Advanced RISC Machine) or Real-Time Operating System embedded measurement and control system solution is adopted: ARM Cortex-M7 which is commonly used in the industry is selected as the microprocessor, and an RT-thread is selected as the RTOS. The M7 processor is integrated with rich resources such as FLASH and RAM, an external memory interface, an ADC, an RTC, and a multi-channel Universal Synchronous/Asynchronous Serial Receiver/Transmitter (USART), SPI, I2C, and Ethernet, which can greatly reduce hardware costs and accelerate project design.
2. In a central processor module, a FLASH external memory is expanded via an SPI interface, and is used as a storage space for recording lightning strike events; communication with a VCO-integrated PLL chip, such as an ADF4360-6 chip is achieved by the SPI interface, to control the output of a high-frequency clock of 1.2 G; and decoding logic is realized by an EPLD, and reading and writing of each counter and ADC are realized in combination with 74HC245 bus transceiving/74HC373 latch, etc.
3. In a signal collection and comparison module, a Rogowski coil is used to collect a leakage current of the surge protective device, and a voltage sensor is used to collect an alternating-current voltage. A voltage threshold Vr1 of a comparator 1 needs to be set according to the lower-limit action current of the surge protective device, for example, corresponding to the current value of 50 A; and a voltage threshold Vr2 of a comparator 2 should be lower than Vr1, and the set value corresponds to 40 A.
4. In a lightning strike counting and timing module, the VCO-integrated PLL chip ADF4360-6 is used to output a high-frequency analog signal of 1.2 G; then the analog signal is converted into a clock CLK of a PECL level by a clock distribution chip AD9515; and the CLK is used as clock input of two high-speed counters. The two high-speed counters each use one 8-bit high-speed counter MC100E P016 and one 24-bit general-purpose counter which are be connected in series, to form a 32-bit counter; and thus the maximum counting of 4 G is realized, and the maximum timing is approximately 3 s.
5. In an analog-to-digital conversion module, first a 1.2 G high-speed clock undergoes frequency division by 16 and enters a beat generator, to generate four sequential pulses as sequential start signals of a TIADC; four AD7825 with a conversion rate of 2 Mbps are used to constitute the TIADC, so as to realize fast sampling of lightning voltage V0 and lightning current V1; and obviously, the maximum sampling rate is 8 Mbps. In addition, conventional sampling such as alternating-current voltage V0, a total leakage current V2 of the surge protective device, temperature V4 and humidity V5 is completed using ADCs integrated on the processor.
6. In the microprocessor program, at least five interrupt response programs are designed:
   (1) reference software timer interrupt: the interrupt frequency is 1 ms, and continuous accumulation and cyclic counting of the tick value are achieved;
   (2) external ADC conversion complete interrupt: a falling edge is used for triggering, and sampled data (lightning voltage V0 and lightning current V1) of the TIADC are read;
   (3) internal ADC conversion complete interrupt: sampled data of ADCs integrated on the processor (alternating-current voltage V0, total leakage current V2 of the surge protective device, temperature V4 and humidity V5) are read;
   (4) counter start-counting interrupt: which is triggered by a rising edge, and the output value (the lightning strike start time or interval duration) of a high-speed counter 2 and the current calendar time are read; and
   (5) counter stop-counting interrupt: which is triggered by a rising edge, and the output value (lightning strike duration) of a high-speed counter 1 and the current calendar time are read.
7. After being mounted on the surge protective device, the counter apparatus is powered on to start running. High-speed sampling of the accumulation of the number of impulses, the timing of impulse duration and the duration of an interval between impulses, and the lightning voltage and the lightning current is completed. And the reception, processing, storage and analysis of the measurement data are achieved. In a practical implementation process, the reception, processing, storage, and analysis of the measurement data may be performed in conjunction with actual requirements, and will not be described in detail herein.

### Scenario Embodiment IV

With reference to the lightning strike counting and sampling method in the embodiments, in this scenario embodiment, how to achieve service life prediction of a surge protective device according to data recorded in a counter is described.

Parameter analysis of the surge protective device is as follows:
1. The nominal discharge current In thereof is 10 kA, which means the highest value of the impulse current that the surge protective device can bear when subjected to standard 8/20 microsecond of lightning surge for 10 times. A common surge protective device for a power supply can withstand a nominal discharge current impulse for at most 20 times.
2. The maximum discharge current Imax thereof is 20 kA, which indicates that the surge protective device can withstand current impulse of 20 kA twice without damage.
3. Repetitive Charge Transfer Rating (Qrs), of which the specific parameter is not provided by manufacturer of the surge protective device. According to technical specifications released by a certain association, the Qrs of a low-voltage alternating-current surge protective device is 0.4 C. That is to say, the surge protective device can withstand an accumulative lightning strike energy of a maximum of 0.4 C.
4. Total leakage current, of which the specific parameter is not provided by manufacturer of the surge protective device. According to technical specifications released by a certain association, the total leakage current of the low-voltage alternating-current surge protective device does not exceed 0.05 mA.

Therefore, in the embodiments of the present disclosure, the four parameters may be comprehensively taken into consideration, so as to perform operating condition evaluation and service life prediction of the surge protective device. For example:
1. When the total leakage current obtained by conventional sampling reaches 0.10 mA and exceeds 0.05 mA, it indicates that the performance of the surge protective device starts to deteriorate, and replacement may be required.
2. Since high-speed sampling is achieved, the peak value of the impulse current can be recorded. If the number of times that the peak current is around the nominal discharge current is 15, it indicates that the number of times that the surge protective device can withstand the similar lightning strike intensity may be only 5 times left.
3. By integrating the lightning current over time, the accumulative charge amount (Coulomb) flowing through the surge protective device can be calculated. If the accumulative charge amount reaches 0.4 C, it indicates that the surge protective device is subjected to excessive energy, and needs to be replaced as soon as possible.

In conclusion, the embodiments of the present disclosure provide a lightning strike counting method and apparatus for a communication power supply. In a practical implementation process, the technical solutions provided in the embodiments of the present disclosure are not limited to be applied to communication lightning protection scenarios, and are also applicable to different scenarios such as the determination of a power grid fluctuation impact in power grid scenarios, and measurement of the power grid fluctuation impact, and can also be used for overvoltage damage evaluation and accurate analysis of equipment such as a power supply.

Currently, various lightning strike counters for a communication power supply on the market only simply record the number and time of lightning strikes, which serve as basic references for performance detection and service life estimation of the surge protective devices. Key operation parameters, such as the number of repeated impulses, time and discharge energy, during the lightning strikes are not precisely recorded, thus the local frequency of lightning strikes cannot be clearly and accurately learned, and the real operating conditions of the surge protective devices cannot be mastered, which cannot provide important basis for inspection of the surge protective devices. The actual function and effect of these lightning strike counters are very basic.

In order to overcome the disadvantages of various current lightning strike counters for a communication power supply on the market, the technical solutions of the embodiments of the present disclosure realize high-precision, high-speed and low-cost measurement by skillfully applying innovative technologies such as high-speed counting and interleaved sampling, such that a lightning strike discharge process can be accurately and completely recorded and faithfully reproduced; moreover, the lightning strike counters have a small volume and have no sealing requirement, and may also be integrated in equipment such as a rectifier. The present disclosure allows users to clearly and intuitively learn the frequency of lightning impulses, master the operating condition of the surge protective device for a power supply, and perform effective prediction and estimation (for example, by means of parameters such as impulse time, impulse duration and leakage current, in combination with characteristic parameters of the surge protective device, the degradation trend of the surge protective device is scientifically calculated, and the service life of the surge protective device is predicted). The present disclosure facilitates fault location and design improvement, and supports real-time and accurate lightning strike warning, and quick and efficient predictive maintenance. The present disclosure has significant advantages such as real-time measurement, accurate counting, superior performance, significant effect, low cost, and easy implementation.

In the lightning strike counting method for a communication power supply provided in embodiments of the present disclosure, conventional sampling is used for slow signals such as alternating-current voltage, total leakage current, temperature and humidity, and high-speed sampling is used for lightning voltage and lightning current in a lightning strike duration, thereby reducing hardware costs. General-purpose counters are used for counting of the number of lightning strikes, thereby reducing hardware costs; the timing of the single impulse duration and the duration of an interval between impulses is achieved by using high-speed counters to realize accurate metering; and the method of connecting the high-speed counters and the general-purpose counter in series is used to expand the high-speed counting range and reduce hardware costs. Lightning voltage V0 and lightning current V1 in the lightning impulse duration are sampled using a TIADC technology, thereby achieving high speed, low power consumption and low cost; after conversion by each ADC in the TIADC is completed, an output result is latched, thereby reducing the performance requirements of the microprocessor; after conversion by each ADC in the TIADC is completed, the same interrupt signal is outputted, thereby reducing the number of interrupt signals and interrupt response overhead, and reducing hardware costs; and in an interrupt response program of the TIADC, the conversion output values of the ADCs are read sequentially to avoid time misalignment, thereby realizing accurate metering. Whether a lightning current waveform is similar to an arched pulse is analyzed, and it is determined whether it is a lightning impulse or a power grid fluctuation impact, so as to realize more accurate lightning strike counting; in addition, the measurement of the power grid fluctuation impact can also be used for overvoltage damage evaluation and accurate analysis of equipment such as a power supply.

The lightning strike counting apparatus for a communication power supply provided in the embodiments of the present disclosure can be deployed in a first-level surge protective device, a second-level surge protective device or a third-level surge protective device of a communication equipment room and a base station, and then in terms of hardware, a voltage sensor (collecting a power grid voltage borne by the lightning arresters) and a current sensor (collecting a leakage current of the lightning arresters) need to be added. In addition to recording and counting the number of times each surge protective device is exposed to lightning strikes, a plurality of operation parameters, such as an impulse time, an impulse duration, and a leakage current in the process of sensing a lightning strike discharge can also be monitored and recorded; and a lightning current waveform and lightning strike energy can be restored by means of relevant mathematical calculation and processing, such that a user can clearly and intuitively learn the impulse condition corresponding to the lightning strike, and the operating conditions of the surge protective devices can be effectively predicted and estimated. In addition, the apparatus can also be integrated in equipment such as a rectifier for a communication power supply, thereby facilitating fault location and design improvement, and improving the reliability of the equipment.

In the lightning strike counting method and apparatus for a communication power supply provided in embodiments of the present disclosure, compared with the related art, the beneficial effects of the technical solutions of the embodiments of the present disclosure are: 1. Complete recording, and comprehensive understanding of a lightning strike process: the lightning strike counter apparatus and technology implemented in the embodiments of the present disclosure can monitor and record a plurality of operation parameters during a lightning strike discharge process, including a lightning strike discharge start time, the number of repeated impulse discharges, the duration of each impulse and the interval between impulses, the lightning strike voltage, the lightning strike current, etc. The recorded data is sufficient and complete, and it is very easy to restore and reproduce the discharge process by means of these data, thereby facilitating visually understanding a lightning strike condition by a user. 2. Fine recording and facilitating deep analysis: in the embodiments of the present disclosure, operating parameters of the lightning strike discharge process are recorded, and the real-time performance is high and the precision is high. For example, the recording precision of the lightning strike time is on the order of ms, and the precision of the impulse duration and the interval duration is on the order of ns; and high-speed sampling of the lightning strike current and voltage is realized by means of the TIADC technology, and the sampling frequency is tens of megabytes or higher. After further calculation processing of high-precision data, important information such as current peak value, residual voltage peak value, effective value, and impulse energy in the impulse process can be obtained, thereby facilitating users in further analyzing the lightning strike process and the operating condition of the surge protective device. 3. Accurate counting: since multiple repeated impulse discharges in one lightning strike discharge process are recorded, the number of lightning strikes and the number of impulses are respectively counted, avoiding repeated counting errors of the number of lightning strikes. In addition, the current waveform of the lightning impulse exhibits a certain regular arched pulse of approximately 8/20 us, while the power grid fluctuation impact exhibits a random and irregular trend. Since high-speed sampling at tens of megabytes or higher is achieved, by analyzing whether the lightning current waveform is similar to an arched pulse by software, it is determined whether it is a lightning impulse, preventing incorrect counting of taking the power grid fluctuation impact as a lightning impulse, thereby achieving more accurate lightning strike counting. 4. Prediction of operating conditions: by a software compensation algorithm, interference influence of temperature and humidity on the leakage current is reduced, achieving more accurate leakage current monitoring of the surge protective device. Moreover, in conjunction with comprehensive criterion of other parameters such as Qrs of international or industry standards and the number of impulses, the operating conditions of the surge protective devices can be effectively predicted and the service life is estimated. 5. Cost leadership: in the embodiments of the present disclosure, high-speed timing is achieved by phase-locked frequency multiplication, and connecting high-speed counters and low-speed counter in series; in addition, high-speed sampling is also achieved using the TIADC technology. The technical combination of high-speed timing and high-speed sampling has distinct advantages of high precision, high speed, low power consumption, and huge cost advantage. Accordingly, the present disclosure can be widely used in communication equipment rooms and power supply equipment, can greatly strengthen lightning protection measures for communication networks, reduce lightning strike disasters and accident losses, and ensure communication network security.

The content above merely relates to preferred embodiments of the present disclosure, and is not intended to limit embodiments of the present disclosure. For a person skilled in the art, embodiments of the present disclosure may have various modifications and changes. Any modifications, equivalent replacements, improvements, etc. made within the principle of embodiments of the present disclosure shall all fall within the scope of protection of embodiments of the present disclosure.

## Claims

1. A lightning strike counting method for a communication power supply, comprising:
generating a plurality of sequential pulses for a plurality of Analog-to-Digital Converters ,ADCs, in a Time-Interleaved Analog-to-Digital Converter ,TIADC;
sequentially starting the plurality of ADCs to sample a lightning strike voltage and a lightning strike current according to the plurality of sequential pulses; and
sequentially outputting, by the plurality of ADCs, sampling signals, to complete lightning strike counting of a communication power supply.

2. The method according to claim 1, wherein the method further comprises:
when a lightning strike occurs, using a general-purpose counter to count the number of lightning strikes, and using high-speed counters to measure a single impulse duration of the lightning strike and a duration of an interval between impulses of the lightning strike.

3. The method according to claim 2, wherein before using the general-purpose counter to count the number of lightning strikes, and using the high-speed counters to measure the single impulse duration of the lightning strike and the duration of the interval between impulses of the lightning strike, the method further comprises:
performing conditioning processing on a leakage current of a lightning arrester, to obtain a comparison voltage;
in a case where the comparison voltage is greater than a first voltage threshold, determining that a lightning strike has occurred; and
in a case where the comparison voltage is greater than a second voltage threshold, determining to start sampling the lightning strike voltage and the lightning strike current; wherein the second voltage threshold is less than the first voltage threshold.

4. The method according to claim 3, wherein using the general-purpose counter to count the number of lightning strikes, and using the high-speed counters to measure the single impulse duration of the lightning strike and the duration of the interval between impulses of the lightning strike, comprises:
obtaining a first level signal according to a comparison result of the comparison voltage and the first voltage threshold;
according to a rising edge of the first level signal, triggering the general-purpose counter to increase the counting number of lightning strikes by 1;
in a case where the first level signal is at a high level, using a first high-speed counter to measure the single impulse duration of the lightning strike; and if the first level signal is at a low level, using a second high-speed counter to measure the duration of the interval between impulses of the lightning strike.

5. The method according to claim 4, wherein using the general-purpose counter to count the number of lightning strikes, and using the high-speed counters to measure the single impulse duration of the lightning strike and the duration of the interval between impulses of the lightning strike, comprises:
triggering a first interrupt response signal according to the rising edge of the first level signal, and acquiring, by the first high-speed counter, a timing start time of the single impulse duration of the lightning strike according to the first interrupt response signal; and
triggering a second interrupt response signal according to a falling edge of the first level signal, and acquiring, by the first high-speed counter, a timing end time of the single impulse duration of the lightning strike according to the second interrupt response signal.

6. The method according to claim 2, wherein using the high-speed counters to measure the single impulse duration of the lightning strike and the duration of the interval between impulses of the lightning strike, comprises:
measuring the single impulse duration of the lightning strike and the duration of the interval between impulses of the lightning strike by connecting the high-speed counters and the general-purpose counter in series.

7. The method according to claim 1, wherein generating the plurality of sequential pulses for the plurality of ADCs in the TIADC comprises:
performing frequency division processing on a high-frequency clock, and generating the plurality of sequential pulses according to the high-frequency clock after frequency division.

8. The method according to claim 1, wherein according to the plurality of sequential pulses, sequentially starting the plurality of ADCs to sample the lightning strike voltage and the lightning strike current, comprises:
simultaneously inputting the lightning strike voltage or the lightning strike current to the plurality of ADCs, and sequentially starting the plurality of ADCs according to the sequential pulses to perform analog-to-digital conversion, so as to complete sampling of the lightning strike voltage or the lightning strike current.

9. The method according to claim 8, wherein sequentially starting the plurality of ADCs to sample the lightning strike voltage and the lightning strike current, comprises:
alternately sampling, by m ADCs, the same lightning strike voltage or lightning strike current according to the plurality of sequential pulses; wherein a clock phase deviation between adjacent ADCs is 2π/m.

10. The method according to claim 1, wherein sequentially outputting, by the plurality of ADCs, the sampled signals, comprises:
after performing, by the plurality of ADCs, analog-to-digital conversion on the sampled signals, triggering third interrupt response signals;
sequentially reading an output of the plurality of ADCs on the basis of a first third interrupt response signal, until the output of an ADC is invalid; and
according to an m-th third interrupt response signal, sequentially reading outputs of ADCs from an output of an ADC of which reading of an (m-1)th third interrupt response signal has been completed, until sequential reading of the outputs of the plurality of ADCs is completed.

11. The method according to claim 1, wherein after sequentially starting the plurality of ADCs to sample the lightning strike voltage and the lightning strike current, the method further comprises:
latching a sampling result.

12. A lightning strike counting apparatus for a communication power supply, comprising: a microprocessor, a beat generator, a voltage sensor, a current sensor, a Time-Interleaved Analog-to-Digital Converter ,TIADC, wherein
the microprocessor is configured to generate a high-frequency clock;
the beat generator is configured to generate a plurality of sequential pulses for a plurality of Analog-to-Digital Converters ,ADCs, in the TIADC according to the high-frequency clock;
the voltage sensor is configured to collect a lightning strike voltage, and perform conditioning processing on the lightning strike voltage;
the current sensor is configured to collect a lightning strike current, and perform conditioning processing on the lightning strike current; and
the TIADC is configured to sequentially start, according to the plurality of sequential pulses, the plurality of ADCs to sample the lightning strike voltage and the lightning strike current.

13. The apparatus according to claim 12, wherein the apparatus further comprises: a general-purpose counter and high-speed counters; wherein
the general-purpose counter is configured to count the number of lightning strikes; and
the high-speed counters are configured to measure a single impulse duration of the lightning strike and a duration of an interval between impulses of the lightning strike.

14. The apparatus according to claim 12, wherein the apparatus further comprises: a first voltage comparator and a second voltage comparator; wherein
the first voltage comparator is configured to compare a comparison voltage with a first voltage threshold, determine whether a lightning strike has occurred, and output a first level signal; and
the second voltage comparator is configured to compare the comparison voltage with a second voltage threshold, determine whether to start sampling the lightning strike voltage and the lightning strike current, and output a second level signal.

15. The apparatus according to claim 12, wherein
the microprocessor is further configured to trigger a first interrupt response signal according to a rising edge of the first level signal, wherein the first interrupt response signal is configured to instruct a first high-speed counter in the high-speed counters to acquire a timing start time of a single impulse duration of the lightning strike; and
the microprocessor is further configured to trigger a second interrupt response signal according to a falling edge of the first level signal, wherein the second interrupt response signal is configured to instruct the first high-speed counter to acquire a timing end time of the single impulse duration of the lightning strike.

16. The apparatus according to claim 12, wherein
the microprocessor is further configured to trigger third interrupt response signals after the plurality of ADCs sample the lightning strike voltage and the lightning strike current; wherein the third interrupt response signals are configured to instruct reading of outputs of the plurality of ADCs.
